# DEMANDE DE BREVET EUROPEEN

(11) **EP 0 766 091 A1**
(43) Date de publication de la demande: **02.04.1997**
(21) Numéro de dépôt: 96401641.4
(22) Date de dépôt: 23.07.1996
(51) Int. Cl.: G01R 15/20, G01R 15/00

(54) **Dispositif de réglage de zéro d'un appareil de mesure de courant continu**

(30) Priorité: 26.07.1995 FR 9509116
(71) Demandeur: CHAUVIN ARNOUX Société dite:, 75018 Paris (FR)
(72) Inventeur: Arnoux, Axel, 75015 Paris (FR); Piaud, Didier, 92100 Boulogne (FR)
(74) Mandataire: Berger, Helmut

(57) **Abrégé**

L'invention concerne un dispositif de réglage de zéro d'un appareil de mesure de courant continu.

Cet appareil est du type comprenant, comme capteur (1), des cellules à effet Hall ou des éléments magnéto-résistifs fonctionnant en mesure directe ou en annulation de flux. L'appareil est caractérisé en ce qu'il comprend des moyens convertisseurs analogique-numériques (11) destiné à mesurer la tension de décalage en sortie (3) de la chaîne de mesure, une mémoire pour mémoriser le résultat de cette mesure, un dispositif de calcul (10) d'un signal de correction du décalage et un convertisseur numérique-analogique (13) dont la tension de sortie est envoyée à un amplificateur de mesure (2) monté dans la chaîne de mesure et adapté pour établir la somme algébrique du signal de mesure et du signal de correction de décalage.

L'invention est utilisable pour des pinces ampèrimètriques.

## Description

L'invention concerne un dispositif de réglage de zéro d'un appareil de mesure de courant continu, telle qu'une pince ampèremètrique, utilisant comme capteur des cellules à effet Hall ou des éléments magnéto-résistifs fonctionnant en mesure directe ou en annulation de flux.

Dans les appareils de mesure de ce type, des variations de zéro peuvent provenir de différentes causes, à savoir de dérives de décalage du ou des capteurs magnétiques, des dérives de décalage de la chaîne d'amplification et de la rémanence du circuit magnétique de mesure. Toutes ces variations, dues aux variations de température ou aux mesures précédentes, introduisent une erreur de mesure si elles ne sont pas corrigées.

Pour corriger ces variations de zéro il est connu d'équiper l'appareil, par exemple une pince ampèremètrique, pour courant continu, d'une molette de réglage. Or, ce dispositif à commande mécanique est relativement lent et délicat. Il nécessite d'agir sur la molette tout en lisant la valeur de la tension de sortie de la pince sur le voltmètre de mesure, en tenant compte du temps de réponse du voltmètre. De plus, ce système peut être facilement déréglé.

Il est également connu d'effectuer, par appui sur un bouton poussoir, une mise en mémoire analogique du zéro. Le dispositif de réglage par mise en mémoire analogique présente l'inconvénient qu'il est difficile à mettre en oeuvre et introduit des dérives lentes dues aux composants de mise en mémoire de décalage.

La présente invention a pour but de proposer un dispositif de réglage de zéro qui ne présente pas les inconvénients des dispositifs connus.

Pour atteindre ce but, le dispositif de réglage de zéro selon l'invention est caractérisé en ce qu'il comprend un convertisseur analogique-numérique destiné à mesurer la tension de décalage en sortie de la chaîne de mesure, une mémoire pour mémoriser le résultat de cette mesure, un dispositif de calcul d'un signal de correction du décalage et un convertisseur numérique-analogique dont la tension de sortie est envoyée à un amplificateur de mesure monté dans la chaîne de mesure et adapté pour établir la somme algébrique du signal de mesure et du signal de correction de décalage.

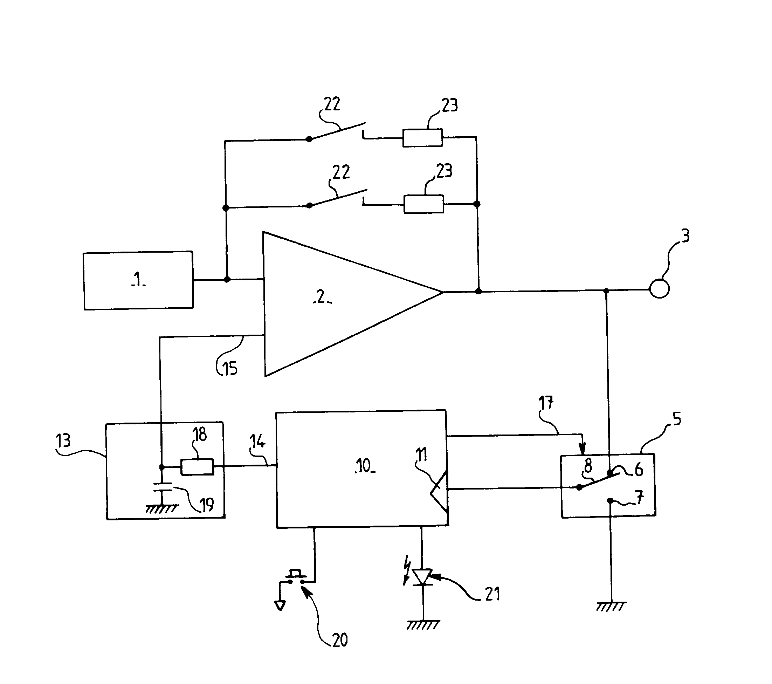

L'invention sera mieux comprise et d'autres buts, caractéristiques, détails et avantages de celle-ci apparaîtront plus clairement dans la description explicative qui va suivre faite en référence à la figure unique annexée donnée uniquement à titre d'exemple illustrant, sous forme d'un schéma bloc synoptique, un mode de réalisation de l'invention.

Sur la figure unique, les chiffres de référence 1 et 2 désignent, de façon générale, un capteur magnétique et un amplificateur de mesure de l'appareil par exemple d'une pince ampèremètrique La référence 3 indique la borne de sortiedecelui-ci.

Le dispositif de réglage de zéro dont l'appareil est équipé comprend essentiellement un commutateur analogique 5 qui comporte deux contacts fixes d'entrée 6 et 7 reliés respectivement à la sortie 3 de l'appareil et à une masse de mesure et un contact mobile 8, un système microprogrammé 10 pourvu de moyens convertisseurs analogique-numériques 11 relié au contact mobile 8 du commutateur 5 et un convertisseur numérique-analogique 13 dont les bornes d'entrée et de sortie sont reliées respectivement à une borne de sortie 14 du système microprogrammé 10 et une entrée de correction 15 de décalage de l'amplificateur 2.

Concernant le commutateur analogique 5, il est commandé par le système microprogrammé 10, comme cela est symbolisé par la ligne fléchée 17. Le convertisseur numérique-analogique 13 est avantageusement constitué par un modulateur de largeur d'impulsion du type PWM. Sur la figure, il est montré comme étant formé par un filtre passe-bas comportant une résistance 18 et un condensateur 19. Le signal en provenance du système microprogrammé 10 est converti par le convertisseur 15 en une tension continue de correction et filtré.

Au système microprogrammé 10 est associé un organe de commande 20 avantageusement formé par un bouton poussoir et un indicateur de zéro 21 comportant une diode électroluminescente. Il est encore à noter que le gain de l'amplificateur de mesure 2 est variable en actionnant des interrupteurs 22 appropriés montés dans des circuits de contre-réactions montés en parallèle et chacun pourvu d'une résistance 23.

Il est encore à noter que le système microprogrammé assure les différentes fonctions du dispositif, à savoir la conversion analogique-numérique, le calcul des valeurs de mesure, la mise en mémoire des valeurs calculées, la conversion numérique-analogique et la commande du commutateur.

On décrira ci-après le fonctionnement du dispositif de réglage de zéro selon la présente invention.

Le processus de réglage est commandé par l'appui sur le bouton poussoir 20, la pince ampèremètrique étant alors hors courant à mesurer. Le système microprogrammé commande le commutateur analogique 5 pour que le convertisseur analogique-numérique 11 puisse mesurer la tension de décalage à la sortie 3 de la chaîne de mesure. Le résultat de cette mesure, après un traitement par calcul approprié, est mémorisé et commande le convertisseur numérique-analogique 13 dont la tension de sortie est envoyée, après filtrage, à l'amplificateur de mesure 2 qui fait la somme algébrique du signal de mesure et du signal de la correction du décalage appliquée à l'entrée 15 de l'amplificateur.

Le système microprogrammé effectue également au cours de ce processus la différence entre la sortie 3 de la chaîne de mesure et la masse mesure 7. En fonction de cette différence, il corrige la valeur du convertisseur numérique-analogique 13. L'opération qui vient d'être décrite est réitérée jusqu'à ce que la différence de tension entre la sortie et la masse de mesure est inférieure ou égale à la valeur désirée. La valeur du modulateur de largeur 13 est mémorisée jusqu'à un nouvel appui sur le bouton poussoir.

L'indicateur de zéro 21 donne des informations sur le déroulement du processus de réglage. Le clignotement de la diode électroluminescente signale que l'opération de réglage de zéro est en cours.

Le nombre d'itérations du réglage de zéro est limité. Il est fonction de la résolution du convertisseur analogique-numérique. Si, au bout de ce nombre, le réglage de zéro n'a pu être obtenu, l'indicateur de zéro 21 reste allumé signalant ainsi une anomalie.

Le dispositif de réglage de zéro selon l'invention basé sur la mise en mémoire numérique du décalage, présente les avantages d'une grande facilité d'utilisation, de constituer une solution économique ne comportant pas de pièces mécaniques, et d'indiquer la validité du réglage de zéro. De plus cette solution peut être appliquée aux pinces ampèremètriques pour courant continu à affichage numérique et/ou à sortie analogique, ainsi qu'à tout appareil de mesure nécessitant une prise en compte d'une erreur de mesure au zéro ou d'une différence. Dans ce dernier cas, la prise en mémoire de la valeur de référence devra se faire sur le conducteur concerné.

## Revendications

1. Dispositif de réglage de zéro d'un appareil de mesure de courant continu, telle qu'une pince ampèremètrique, du type comprenant, comme capteur, des cellules à effet Hall ou des éléments magnéto-résistifs fonctionnant en mesure directe ou en annulation de flux, caractérisé en ce qu'il comprend des moyens convertisseurs analogique-numériques (11) destiné à mesurer la tension de décalage en sortie (3) de la chaîne de mesure, une mémoire pour mémoriser le résultat de cette mesure, un dispositif de calcul (10) d'un signal de correction du décalage et un convertisseur numérique-analogique (13) dont la tension de sortie est envoyée à un amplificateur de mesure (2) monté dans la chaîne de mesure et adapté pour établir la somme algébrique du signal de mesure et du signal de correction de décalage.

2. Dispositif selon la revendication 1, caractérisé en ce qu'il comprend un système microprogrammé (10) destiné à assurer les différentes fonctions du dispositif, telles que les fonctions du calcul, de la mise en mémoire des valeurs calculées et des conversions précitées.

3. Dispositif selon la revendication 2, caractérisé en ce qu'un commutateur (5) est interposé entre les moyens convertisseur analogique-numérique (11) et la borne de sortie (3) de l'appareil et pourvu de deux contacts fixes (6, 7) de connexion des moyens convertisseur à ladite borne de sortie et à une masse de mesure.

4. Dispositif selon l'une des revendications précédentes, caractérisé en ce que le convertisseur numérique-analogique (13) est réalisé sous forme d'un modulateur de largeur d'impulsion.

5. Dispositif selon l'une des revendications précédentes, caractérisé en ce qu'il comprend un indicateur de zéro (21) adapté pour donner des informations sur le déroulement du processus de réglage.

6. Dispositif selon la revendication 5, caractérisé en ce que l'indicateur de zéro (21) comprend un organe telle qu'une diode électroluminescente, avantageusement à trois états indiquant respectivement que le processus de réglage est en cours, que le réglage a abouti et que le réglage n'a pas abouti.

7. Dispositif selon l'une des revendications précédentes, caractérisé en ce qu'il comprend un dispositif de déclenchement (30) du réglage de zéro, tel qu'en bouton poussoir.

8. Dispositif selon l'une des revendications précédentes, caractérisé en ce qu'il comprend des moyens (22, 23) de variations du gain de l'amplificateur de mesure (2).

9. Dispositif selon l'une des revendications 2 à 8, caractérisé en ce que le système microprogrammé (10) est adapté pour mémoriser une valeur de décalage établie pendant un processus de réglage de zéro jusqu'au processus de réglage suivant.
